# EUROPEAN PATENT APPLICATION

(11) **EP 2 549 677 A1**
(43) Date of publication of application: **23.01.2013**
(21) Application number: 11174850.5
(22) Date of filing: 21.07.2011
(51) Int. Cl.: H04L 7/00

(54) **Method for operating a communication system and communication system**

(71) Applicant: Siemens Aktiengesellschaft, 80333 München (DE)
(72) Inventor: Moen, Stian Oroe, 7036 Trondheim (NO)

(57) **Abstract**

It is described a method for operating a communication system comprising a first device with a working oscillator and a second device with a reference oscillator, the method comprising calibrating the working oscillator of the first device connected to an asynchronous serial communications bus, calibrating comprising defining a measurement time T_{A}, measuring and selecting a predefined pulse space T₁ of a first signal formed by a plurality of predefined discrete pulse spaces and generated by a second device comprising a reference oscillator and received by said first device during T_{A} over said asynchronous serial communications bus.

## Description

### Field of invention

The present invention relates to a method for operating a communication system, a communication system, and a program element.

### Background

Communication systems generally comprise several devices, e.g. sensors and actuators. To reduce the wiring complexity these devices are connected via asynchronous serial communication busses.

Communication over asynchronous serial communication busses relies on predefined bit rates. Accordingly, two devices communicating over an asynchronous communication bus have to be operated at the same bit rate derived from the frequency of their respective working oscillators. As bit rate increases the accurateness of the oscillators becomes more important to avoid transmission errors.

Providing each device with a high precision oscillator may be expensive and/or may not be possible due to environmental conditions like for example high pressure or extreme temperatures.

Hence, there may be a need for a method for operating a communication system, a communication system and a program element offering a higher flexibility concerning the choice of oscillators.

### Summary of the Invention

This need may be met by the subject matter according to the independent claims. Advantageous embodiments of the present invention are described by the dependent claims.

According to a first aspect of the invention there is provided a method for operating a communication system comprising a first device with a working oscillator and a second device with a reference oscillator, the method comprising calibrating the working oscillator of the first device connected to an asynchronous serial communications bus, calibrating comprising defining a measurement time T_{A}, measuring and selecting the shortest pulse space T₁ of a first signal formed by a plurality of predefined discrete pulse spaces and generated by a second device comprising a reference oscillator and received by said first device during T_{A} over said asynchronous serial communications bus.

The pulse space, e.g. the time between a first edge and a subsequent edge, of a signal transmitted via an asynchronous serial communications bus directly relates to the frequency of the oscillator of the transmitting device. The first signal characterized by a plurality of predefined discrete pulse spaces may be a signal intended for any device connected to said asynchronous serial communications bus. The pulse spaces may be multiples of a base period, e.g. a period of the resonance oscillator. The first signal received by the first device may for example be formed by inter alia a first pulse space and another pulse space. These two pulse spaces can be distinguished as the signal is formed by pulse spaces being discrete. The first device may select for example the predefined pulse space to be the pulse space corresponding to two times the period of the resonance oscillator. As the first device may measure the predefined pulse space in terms of its working oscillator it may determine the deviation of the frequency of the working oscillator compared to the reference oscillator. The time T_{A} may be selected to ensure that a predefined pulse space may be detected in the first signal. Selecting the predefined pulse space to be the shortest pulse space may allow for reducing T_{A}.

Calibrating according to this application should be understood as comparing a value, e.g. the frequency, of a working device with the corresponding value of a reference device and determining the difference.

According to a first embodiment of the method for operating a communication system, the method further comprises adjusting the frequency of the working oscillator. Adjusting refers to influencing the working oscillator to reduce the frequency difference between the working oscillator and the reference oscillator, in particular to rendering the difference negligible or even zero. This may enhance transmission speeds. Furthermore, it may allow the first device to perform precise time measurements.

According to a second embodiment of the method for operating a communication system, the method further comprises adapting a calculation of an operating bit rate of the first device. Adapting the bit rate may allow a stable data transmission without requiring an adjustable working oscillator.

According to another embodiment of the method for operating a communication system, the method further comprises validating the calibration of the working oscillator of the first device. Validating the calibration of the working oscillator may help to reduce erroneous transmissions.

According to a further embodiment of the method for operating a communication system validating the calibration of the working oscillator of the first device comprises periodically sending predefined signals from the second device over the asynchronous serial communications bus. This may further reduce erroneous transmissions and enhance the reliability of the asynchronous serial communications bus. The predefined signal may in particular address directly the first device. Alternatively the predefined signal may be a broadcast signal adapted to validate the calibration of the working oscillator of different devices.

According to a still further embodiment of the method for operating a communication system calibrating comprises measuring a length T₂ of the predefined signal with the first device. Predefined implies that the predefined signal has a predefined length, too. This length may be a multiple of the pulse space. Measuring the length T₂ of the signal transmitted by the second device, i.e. with a reference oscillator, with the first device comprising the working oscillator may therefore allow for a more precise calibration.

According to another embodiment of the method for operating a communication system the first signal and/or the predefined signal is a CAN-bus signal.

A CAN-bus is a standardized bus design. Devices for different purposes connectable to and controllable via a CAN-bus are available. Such devices may comprise variable speed drives, actuators, sensors, grid controllers. The method for operating a communication system may therefore be applied to many existing communication systems.

According to a further embodiment of the method for operating a communication system, the method comprises operating the first device in a pressurized environment. A pressurized containment for the first device to be used for example for subsea applications may be less prone to failure. It may require less space and less weight.

According to a second aspect of the invention there is provided a communication system comprising a first device including a working oscillator and a calibration unit, a second device including a reference oscillator, an asynchronous serial communications bus connecting said first device and said second device, the calibration unit being adapted to calibrate said working oscillator using a pulse space of a signal transmittable from the second device over said asynchronous serial communications bus.

Such a communication system may be less expensive as less accurate working oscillators may be used. Furthermore, such a communication system may impose fewer restrictions to the environmental conditions, e.g. temperature, humidity, pressure.

According to an embodiment of the communication system the reference oscillator is a crystal oscillator, in particular a quartz oscillator. Crystal oscillators offer a high frequency accuracy and frequency stability which may make them especially suitable as reference oscillators. Quartz oscillators are available for many frequencies and thus may allow a more flexible choice of bit rates.

According to an embodiment of the communication system the reference oscillator is a ceramic oscillator. Ceramic oscillators are available in small dimensions and may need for operation only few external electrical components. Furthermore, ceramic oscillators may be more resistant to mechanical stress and/or less expensive.

According to an embodiment, the working oscillator can be an RC oscillator. Such oscillator can be easily calibrated and is cost efficient to implement.

According to another embodiment of the communication system the asynchronous serial communications bus is a CAN-bus. A CAN-bus is a standardized bus design. Devices for different purposes connectable to and controllable via a CAN-bus are available. Such devices may comprise variable speed drives, actuators, sensors, grid controllers. The communication system may therefore be composed of standard CAN-bus devices.

According to a third aspect of the invention there is provided a program element, the program element, when being executed by a data processor, is adapted for carrying out the method for operating a communication system as set forth in any one of the claims 1 to 7.

The invention may be realized by means of a computer program respectively software. However, the invention may also be realized by means of one or more specific electronic circuits respectively hardware. Furthermore, the invention may also be realized in a hybrid form, i.e. in a combination of software modules and hardware modules.

### Brief Description of the Drawings

Figure 1 shows a communication system to be at least partly operated below sea-level.
Figure 2 shows an exemplary asynchronous serial communications signal.
Figure 3 shows an exemplary embodiment of a device.
Figure 4 shows a CAN-bus frame.
Figure 5 shows an exemplary embodiment of a calibration and validation routine.

### Detailed Description

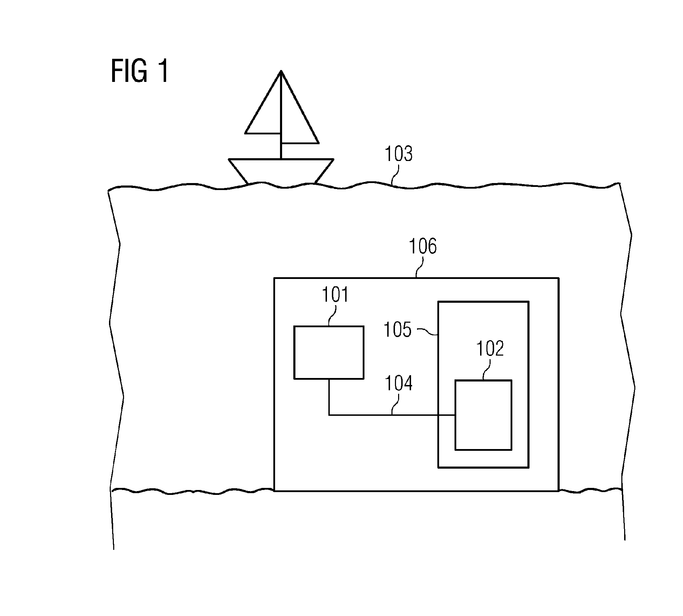

Figure 1 shows a communication system for subsea operation. It may be used for example to control a subsea power grid or variable speed drives (VSD). The communication system comprises a first device 101 and a second device 102, both the first device 101 and the second device 102 being operated below sea-level 103. The first device 101 and the second device 102 are connected to each other via a CAN-bus 104, an asynchronous serial communications bus.

The control electronics used for the second device 102 cannot handle the pressure of up to 300 bars. Accordingly, the second device 102 has been placed in an atmospheric canister 105. The atmospheric canister 105 and the first device 101 have been placed in a fluid filled container 106 with high pressure. In the atmospheric canister 105 there are few restrictions concerning the components that can be used and the second device 102 therefore may comprise a reference oscillator like a crystal oscillator, in particular a quartz oscillator.

In pressurized environments not all oscillators are suitable. Crystal oscillators like quartz oscillators provide the correct frequency by physical vibration at the oscillator frequency. This vibration requires a free space inside the encapsulation. For pressurized subsea applications this presents a problem as these encapsulations typically will collapse due to the increased pressure. It is possible to cast crystal oscillators in a hard material to cope with the pressure. As an alternative all electronics may be placed in an atmospheric canister with penetrators to allow connections. However, this is a very expensive solution which also requires a lot more space and weight. Accordingly, non-vibrating oscillators like for instance RC-oscillators are preferred. RC-oscillators use an RC-network, a combination of resistors and capacitors, for its frequency selective part. An RC-oscillator is though dependent on supply voltage, pressure and temperature and needs to be calibrated to be usable for asynchronous communications like for instance over a CAN-bus.

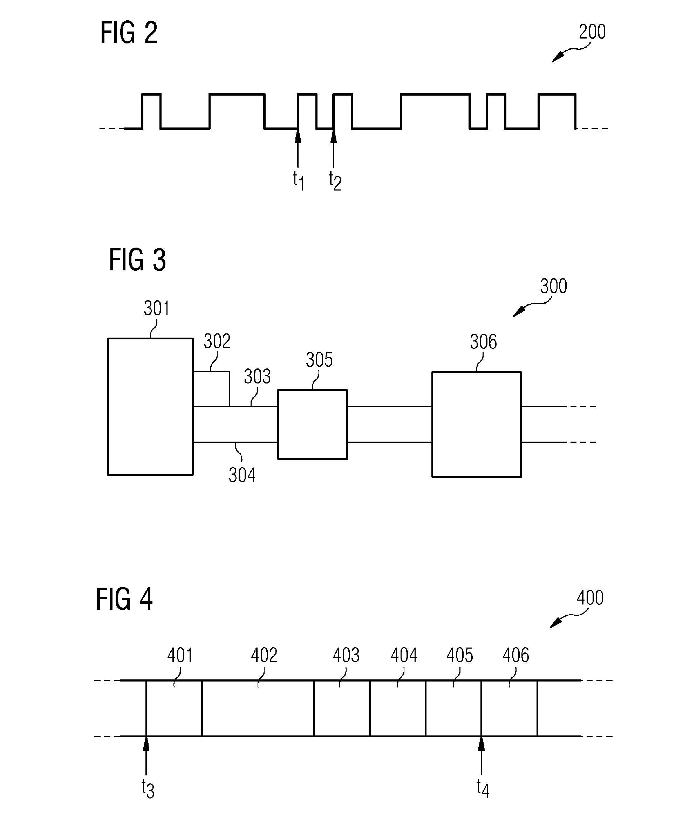

Figure 2 shows an exemplary asynchronous serial communications signal received by the first device 101 which has been transmitted by the second device 102. The level switches from a high level to a low level and back, the pulse space depending on the data transmitted. For a time T_{A} the second device 102 measures the time according to the frequency of its working oscillator between a first rising edge and the subsequent rising edge and stores the shortest pulse space T₁ = t₂ - t₁. Due to the predefined bit rate and the reference oscillator of the second device 102 the first device 101 may determine the deviation of its working oscillator from the reference oscillator, thus calibrating the working oscillator.

The determined deviation may be used to adjust the frequency of an adjustable working oscillator to be essentially equal to the frequency of the reference oscillator. If the working oscillator is for example an RC-oscillator the values of its resistance and its capacitance may be changed. Alternatively or in addition the calculation of the bit rate may be adapted to the determined deviation to assure a stable data transmission. In particular, the bit rate may now be derived from the frequency of the working oscillator and the determined deviation so that the bit rate is equal to the bit rate of the second device 102.

Figure 3 shows another exemplary communication system 300 with a pressurized first device 301 comprising a capturing input 302, a receiving input 303, and a sending output 304. The first device 301 may be a digital programmable device, in particular a microprocessor, a digital signal processor (DSP), a complex programmable logic device (CPLD), a field-programmable gate array (FPGA), or other digital logic.

The first device 301 may include, for example, an Atmel AVR microcontroller AT90CAN32/64/128. An Atmel AVR microcontroller AT90CAN32/64/128 comprises an internal RC-oscillator which may be used as a working oscillator. The internal RC-oscillator may be calibrated using an oscillator calibration (OSCCAL) register. Furthermore, an Atmel AVR microcontroller AT90CAN32/64/128 comprises internal timers and capturing inputs which allows for a measurement of the pulse spaces on the CAN-bus. An Atmel AVR microcontroller AT90CAN32/64/128 also comprises a CAN-bus interface on its chip. This allows for the complete calibration of the first device 301 without added external components. An Atmel AVR microcontroller AT90CAN32/64/128 further includes a system clock. The system clock may be used as a backup working oscillator and enhancing the reliability of the first device 301. Additionally, it may be used to provide an accurate clock signal for auxiliary devices like sensors or actuators using either a pulse width modulation (PWM) output pin or a clock output (CLKO) pin of the Atmel AVR microcontroller AT90CAN32/64/128.

The capturing input 302 of the first device is internally connected to a high frequency timer associated to the working oscillator and externally connected to the receiving input 303 of the first device 301. Receiving input 303 and sending output 304 are connected to the second device 306 via a transceiver 305.

To verify that the calibration has been successful the electronics with the reference crystal oscillator periodically sends a validation frame. This validation frame may also be used for further calibration to achieve even higher accuracy. A standard CAN-bus frame 400 is shown in Figure 4. The CAN-bus frame 400 comprises a start field 401, an arbitration field 402, a control field 403, a cyclic redundancy check field 404, an acknowledge field 405 and an end field 406.

The arbitration field 402 must comprise a unique identifier which triggers the device to be validated. The cyclic redundancy check field 404 may be used to verify that messages can be received without an error. Additionally, the data comprised in the control field 403 may be predefined to provide a further verification means.

Predefining the data comprised in the control filed 403 may enable a more accurate calibration, too. For calibrating the first device may trigger, for example, on the start of frame signal specified by the start field 401 and again on the end of frame signal specified by the end field 406. As the data comprised in the control field 403 is predefined and start field 401, arbitration field 402, cyclic redundancy check field 404 as well as acknowledge field 405 have given length the time T₂ between the start of frame signal t₃ and the end of frame signal t₄ is known and may be compared to the time actually measured by the first device.

The maximum size of an extended identifier CAN-bus frame with 8 bytes of data from the start field 401 to the beginning of the end field 406 is 121 bit. This may therefore provide a calibration with a 121 times higher resolution than the single pulse space time calibration value.

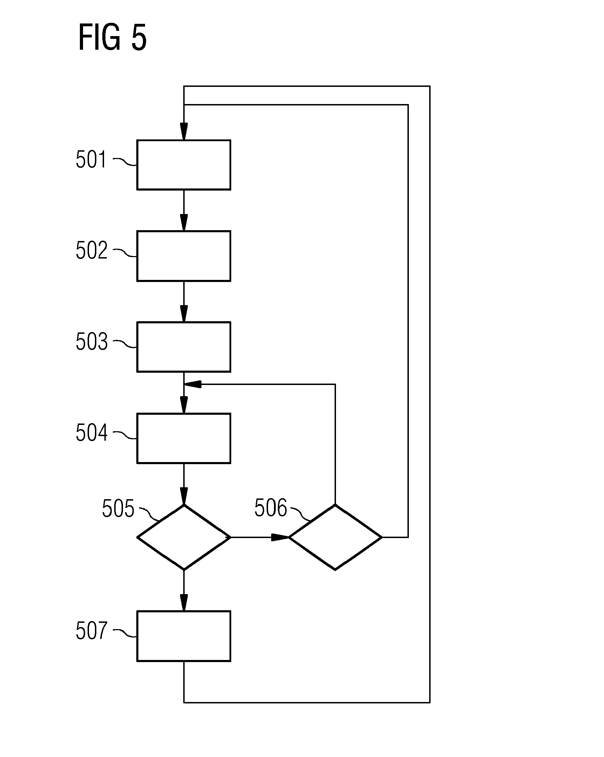

Figure 5 shows an exemplary embodiment of a calibration and validation routine.

In a first step 501 for a time Tₐ a first device measures the pulse space time T₁ between a first rising edge t₁ and the subsequent rising edge t₂ of a CAN-bus signal, an asynchronous serial communications signal, transmitted by a second device. The smallest value Tₘᵢₙ thus obtained is stored.

Based on Tₘᵢₙ, in step 502 the first device determines the deviation of its working oscillator from the reference oscillator, thus calibrating the working oscillator. The determined deviation or calibration value is then used to select a correction value to adjust the frequency of the working oscillator to the frequency of the reference oscillator. Alternatively or in addition a bit rate may the bit rate may be calculated from the now known actual frequency of the reference oscillator.

In the subsequent step 503 the first device is set to operate with the adjusted working oscillator and/or the selected bit rate. Furthermore, the first device starts a timer t_{b} and begins scanning the CAN-bus for CAN-bus frames.

The time T₂ = t₄ - t₃ between the beginning of the start of frame signal and the beginning of the end of frame signal is measured for every received CAN-bus in step 504.

If in step 505 it is determined that the CAN-bus frame received is a validation frame the communication is verified and in step 507 the time T₂ may be used for a more precise adjustment of the working oscillator frequency.

Should the CAN-bus frame not be a validation frame the routine proceeds from step 505 to step 506 and determines if t_{b} has reached T_{b}, i.e. the validation time has expired. If the result is positive the routine restarts with step 501. In the opposite case the routine continues scanning the CAN-bus for CAN-bus frames and measuring the time T₂.

Tₐ and T_{b} are times that must be set according to the traffic on the CAN-bus and the desired bit rate. The routine as described hereinbefore may be performed several times. In this way non-linear or non-continuous frequency deviations or adjusting capabilities of working oscillators, in particular RC-oscillators, may be accounted for.

The method for operating an asynchronous serial communications bus hereinbefore has been described for a communication system with a first device and a second device. However, the communication system may comprise more than two devices.

Only one of the devices needs a reference oscillator to establish a stable data transmission. The working oscillators of all the other devices may be calibrated using this reference oscillator. For a stable data transmission it is important that the devices operate at the same bit rate. The absolute value of the bit rate is off minor importance. Therefore, in an application where the actual bit rate is not crucial for other purposes a crystal oscillator may therefore be omitted. In a pressurized system this enables the use of an RC-oscillator and provides a reliable system with no added cost or even reduced cost with respect to crystal oscillators. No casting of the crystal oscillators is needed.

As an alternative a casted crystal oscillator may be used by default with an RC-oscillator as a redundant backup oscillator. In case of a fault in the crystal oscillator the system is able to continue to work with the RC-oscillator when the system has been calibrated according to the described routine.

In a non-pressurized environment using an asynchronous serial communications bus like a CAN-bus, for instance a road vehicle, the calibration method leads to reduced component cost.

It should be noted that the term "comprising" does not exclude other elements or steps and the use of articles "a" or "an" does not exclude a plurality. Also elements described in association with different embodiments may be combined. It should also be noted that reference signs in the claims should not be construed as limiting the scope of the claims.

In order to recapitulate the above described embodiments of the present invention one can state: The claimed method, system, and program element may offer substantial advantages over known systems.

## Claims

1. Method for operating a communication system comprising a first device with a working oscillator and a second device with a reference oscillator, the method comprising calibrating the working oscillator of the first device connected to an asynchronous serial communications bus, calibrating comprising
defining a measurement time T_{A},
measuring and selecting a predefined pulse space T₁ of a first signal formed by a plurality of predefined discrete pulse spaces and generated by a second device comprising a reference oscillator and received by said first device during T_{A} over said asynchronous serial communications bus.

2. Method for operating a communication system according to claim 1, further comprising
adjusting the frequency of the working oscillator.

3. Method for operating a communication system according to any one of claims 1 or 2, further comprising
adapting a calculation of an operating bit rate of the first device.

4. Method for operating a communication system according to any one of claims 1 to 3, further comprising
validating the calibration of the working oscillator of the first device.

5. Method for operating a communication system according to claim 4, wherein validating the calibration of the working oscillator of the first device comprises
periodically sending predefined signals from the second device over the asynchronous serial communications bus.

6. Method for operating a communication system according to claim 5, wherein calibrating comprises measuring a length T₂ of the predefined signal by the first device.

7. Method for operating a communication system according to any one of claims 1 to 6, wherein the first signal and/or the predefined signal is a CAN-bus signal.

8. Method for operating a communication system according to any one of claims 1 to 7, said method comprising operating the first device in a pressurized environment.

9. Method for operating a communication system according to any one of claims 1 to 8, further comprising
determining from the measured and selected pulse space a frequency deviation between the reference oscillator and the working oscillator and calibrating the working oscillator in accordance with the determined frequency deviation.

10. Communication system comprising
a first device including a working oscillator and a calibration unit,
a second device including a reference oscillator,
an asynchronous serial communications bus connecting said first device and said second device,
the calibration unit being adapted to calibrate said working oscillator using a pulse space of a signal transmittable from the second device over said asynchronous serial communications bus.

11. Communication system according to claim 10, wherein
the reference oscillator is a crystal oscillator, in particular a quartz oscillator.

12. Communication system according to claim 10, wherein the reference oscillator is a ceramic oscillator.

13. Communication system according to any one of claims 10 to 12 wherein the asynchronous serial communications bus is a CAN-bus.

14. Program element, the program element, when being executed by a data processer, is adapted for carrying out the method for operating a communication system as set forth in any one of the claims 1 to 9.

15. A computer-readable medium on which there is stored a computer program for processing a physical object, the computer program, when being executed by a data processor, is adapted for controlling and/or for carrying out the method as set forth in any one of the claims 1 to 9.
